# EUROPÄISCHE PATENTSCHRIFT

(11) **EP 1 185 998 B1**
(45) Veröffentlichungstag und Bekanntmachung des Hinweises auf die Patenterteilung: **08.10.2008**
(21) Anmeldenummer: 01915364.2
(22) Anmeldetag: 16.03.2001
(51) Int. Cl.: H01H 71/12, H05K 7/14

(54) **VORRICHTUNG ZUR LAGERICHTIGEN BEFESTIGUNG EINER LEITERPLATTE**
DEVICE FOR PRECISELY FIXING A PRINTED CIRCUIT BOARD
DISPOSITIF DE FIXATION EN POSITION CORRECTE D'UNE PLAQUETTE DE CIRCUITS IMPRIMES

(30) Priorität: 17.03.2000 DE 10013116
(43) Veröffentlichungstag der Anmeldung: 13.03.2002
(73) Patentinhaber: AEG Niederspannungstechnik GmbH & Co. KG, 24534 Neumünster (DE)
(72) Erfinder: GIDAY, Zoltan, 24536 Neumünster (DE); HESS, Burkhard, 24537 Neumünster (DE); SCHWIENKE, Hans-Jürgen, 01309 Dresden (DE)
(74) Vertreter: TBK-Patent
(86) Internationale Anmeldenummer: PCT/EP2001/003038
(87) Internationale Veröffentlichungsnummer: WO 2001/069629

(56) Entgegenhaltungen:
- EP-A- 0 892 594
- DE-A- 19 712 099
- DE-U- 29 815 003
- US-A- 4 281 359
- US-A- 5 331 500

## Beschreibung

Die vorliegende Erfindung bezieht sich auf eine Vorrichtung zur lagerichtigen Befestigung einer Leiterplatte zwischen zusammenzubauenden Gehäuseteilen.

In vielen elektrischen/elektronischen Geräten, wie beispielsweise Auslöseeinheiten für Leistungsschalter, werden inzwischen Leiterplatten verwendet, die entsprechende elektrische Bauteile tragen. Zum Schutz der Leiterplatten und zum Schutz der Umgebung vor elektrischem Strom werden solche Leiterplatten in der Regel in Gehäusen integriert, so dass sie von dem Gehäuse umschlossen sind.

Häufig sind die Leiterplatten nicht der gesamte elektrische Bestandteil eines elektrischen Geräts, sondern es sind weitere elektrische Bauteile mit der Leiterplatte zu verbinden. Diese Bauteile sind meist in demselben Gehäuse untergebracht oder daran angeordnet.

Üblicherweise ist in einem solchen Fall das Gehäuse aus einem Träger, der die Leiterplatte und gegebenenfalls weitere elektrische Bauteile aufnimmt, und einem Deckel gebildet, der die Leiterplatte umgibt.

Manchmal muss jedoch für Einstellarbeiten ein Zugang zu der Leiterplatte durch den Deckel hindurch möglich sein. Es können aber auch weitere Bauteile später an die Leiterplatte anzustecken sein, indem ein Stecker durch eine Öffnung im Deckel hindurchgeführt wird und in eine passende Fassung auf der Leiterplatte eingesetzt wird. An diesem Stecker kann eine weitere Leiterplatte oder eine weitere Schaltung angebracht sein, um das Gerät durch Aufstecken unterschiedlicher Leiterplatten oder Schaltungen seinem Endzweck anzupassen.

Diese Vorgänge, d.h. das Einstecken weiterer Bauteile an die Leiterplatte und/oder die Einstellarbeiten erfordern eine genaue Einhaltung einer vorgegebenen Lagebeziehung zwischen der Leiterplatte und dem Deckel.

Wird die Leiterplatte direkt mit dem Träger verbunden, können sich Toleranzen der einzelnen Bauteile addieren, so dass die Lagebeziehung zwischen Deckel und Leiterplatte große Abweichungen aufweisen kann. Dabei kann insbesondere die Dickenabweichung der Leiterplatte selbst zu großen Abweichungen führen.

Angesichts dieser Schwierigkeiten kann die vorgenannte Lagebeziehung dadurch sichergestellt werden, dass die Leiterplatte mit dem Deckel verschraubt wird, bevor der Deckel mit dem Träger verbunden wird. Üblicherweise enthält jedoch der Träger weitere elektrische/elektronische Bauteile, die mit der Leiterplatte zu verbinden sind. Somit besteht grundsätzlich die Möglichkeit, die Leiterplatte zunächst mit dem Deckel zu verschrauben, die Leiterplatte dann mit den Bauteilen im Träger zu verbinden und anschließend den Deckel mit dem Träger zu verbinden. Dies bedeutet wegen der schlechteren Zugänglichkeit zu der eingebauten Leiterplatte jedoch, dass häufig eine aufwendige und teure Verbindung (z.B. Verlötung von Hand) einzelner Leitungsdrähte mit der Leiterplatte erforderlich ist.

Zudem besteht die Gefahr, dass diese elektrische Verbindung unterbrochen wird, wenn der möglicherweise relativ schwere vormontierte Träger mit den elektrischen Bauteilen und der Deckel mit der daran angeschraubten Leiterplatte relativ zueinander bewegt werden müssen, um miteinander verbunden zu werden. Dies bedeutet, dass die Leitungsdrähte besonders feste, meist großzügig dimensionierte Leitungsdrähte sein müssen und eine besonders feste Verbindung mit der Leiterplatte geschaffen werden muss. Ferner ist in der Regel eine größere Länge der Leitungsdrähte erforderlich, deren Unterbringung am Träger und/oder im Gehäuse problematisch sein kann.

Aus der EP 0 892 594 A2 ist ein elektronisches Instrument bekannt in welchem Federn zur elektrischen Verbindung mit Abschirmplatten eine Leiterplatte dienen.

Aufgabe der Erfindung ist es, eine Vorrichtung zur lagerichtigen Befestigung einer Leiterplatte, insbesondere für eine Auslöseeinheit eines Leistungsschalters, zwischen zusammenzubauenden Gehäuseteilen vorzuschlagen, die eine einfache, schnelle und kostengünstige Montage der Leiterplatte in den Gehäuseteilen ermöglicht.

Die Aufgabe wird mit einer Vorrichtung gemäß den Merkmalen des Patentanspruchs 1 gelöst.

Gemäß der Erfindung umfasst die Vorrichtung die Leiterplatte zwischen zusammengebauten Gehäuseteilen, wie einem Träger und einem Deckel, und an dem Träger vorgesehene Führungen, die mit Führungsaufnahmen der Leiterplatte in Eingriff sind. Ferner ist mindestens ein federndes Element vorgesehen, das die Leiterplatte in Erstreckungsrichtung der Führungen vorspannt. Ein an dem Deckel ausgebildeter Anschlag beaufschlagt die Leiterplatte gegen die Kraft des federnden Elements.

In einer Ausführungsform der erfindungsgemäßen Vorrichtung kann eine sogenannte schwimmende Lagerung der Leiterplatte zwischen den Gehäusen erzielt werden. In dieser Lagerung ist die Leiterplatte an Führungen geführt und durch das federnde Element in Richtung auf den Deckel vorgespannt. Beim Anbringen des Deckels an dem Träger gelangt ein an dem Deckel vorgesehener Anschlag in Anlage mit der Leiterplatte und drückt diese gegen die Kraft des federnden Elements in Richtung auf den Träger. Durch die Vorspannung der Leiterplatte in Richtung auf den Deckel ist stets eine Anlage des Anschlags an der Leiterplatte sichergestellt. Dies bedeutet, dass die Lagebeziehung zwischen der Leiterplatte und dem Deckel nur noch durch diesen Anschlag bestimmt ist, der vorzugsweise selbst ein Teil des Deckels ist. Folglich ist die Lagebeziehung von weiteren toleranzbehafteten Abmessungen, insbesondere von der Dicke der Leiterplatte, unabhängig.

Die Erfindung ist für eine Vielzahl elektrischer Geräte geeignet; insbesondere eignet sie sich für Auslöseeinheiten für Leistungsschalter, die in großen Stückzahlen produziert werden. Diese Auslöseeinheiten können mit einer gleichen Leiterplatte für verschiedene Auslösungscharakteristiken und Leistungsbereiche als ein Grundgerät versehen werden, das dann beispielsweise durch Aufstecken eines weiteren Elements auf die Leiterplatte oder durch Einstellen von Elementen auf der Leiterplatte seinem Endzweck angepasst werden kann.

In einer Ausführungsform ist die Leiterplatte durch das Zusammenwirken der Führungen am Träger und/oder der Führungsaufnahmen zunächst auf dem Träger geführt gehalten. So können beispielsweise an dem Träger angeordnete elektrische Bauteile an die Leiterplatte angeschlossen werden, ohne dass die Zugänglichkeit zur Leiterplatte durch den Deckel eingeschränkt ist.

Ferner ist somit die mechanische Verbindung zwischen Leiterplatte und Träger bereits hergestellt, so dass einfache und kostengünstige Verbindungstechniken (z.B. Crimpen oder Quetschverbindungen) für den Anschluss der elektrischen Bauteile an die Leiterplatte ausreichen. Zudem können die Leitungen der elektrischen Bauteile des Trägers so bemessen sein, dass ihre Länge gerade zum Anschluss der elektrischen Bauteile an die Leiterplatte ausreicht.

Somit kann vermieden werden, dass übermäßig lange Leitungen später im/am Gehäuse verlegt und festgelegt werden müssen.

Vorteilhafte Ausgestaltungen der Erfindung sind in den Unteransprüchen aufgeführt.

Die Erfindung wird nachstehend anhand eines bevorzugten Ausführungsbeispiels unter Bezugnahmen auf die Zeichnung näher erläutert. Darin zeigt:
Fig. 1 eine teilweise aufgeschnittene Perspektivansicht einer Auslöseeinheit als ein Ausführungsbeispiel der Erfindung;
Fig. 2 eine Einzelheit aus Fig. 1 ebenfalls in teilweise aufgeschnittener Perspektivansicht;
Fig. 3 eine Schnittansicht der Auslöseeinheit aus Fig. 1; und
Fig. 4 eine perspektivische Explosionsdarstellung der Auslöseeinheit aus Fig. 1.

Die Erfindung wird anhand einer Auslöseeinheit für Leistungsschalter als ein Ausführungsbeispiel der Erfindung nachfolgend genauer erläutert.

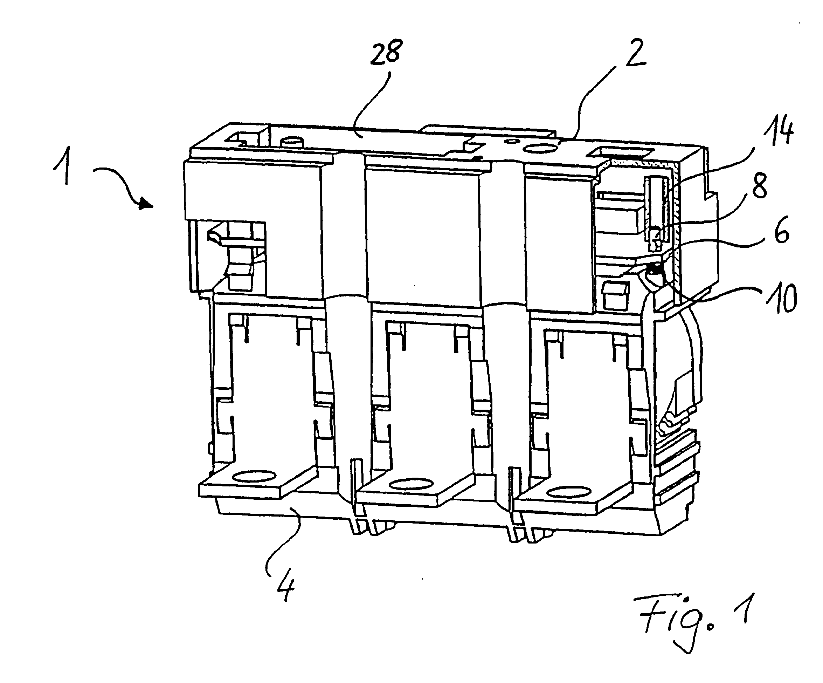

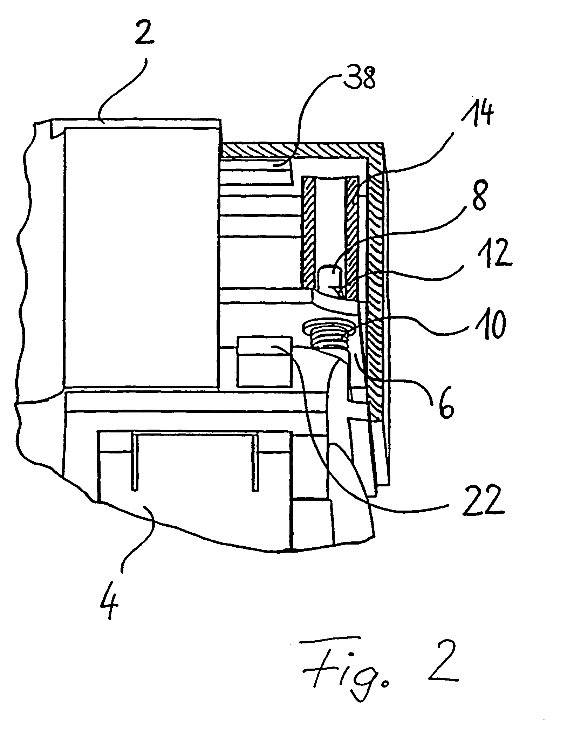

Fig. 1 zeigt eine Auslöseeinheit 1, in welcher eine Leiterplatte 6 zwischen einem Träger 4 und einem Deckel 2 angeordnet und gehalten ist. Fig. 2 zeigt eine Ausschnittsvergrößerung der rechten oberen Ecke in Fig. 1, anhand der die Arbeitsweise der erfindungsgemäßen Vorrichtung erläutert werden soll. Wie in Fig. 2 zu erkennen ist, ist die Leiterplatte 6 über Führungen 8 geführt und auf den Träger 4 aufgesetzt. In Fig. 2 unterhalb der Leiterplatte 6 ist eine Spiralfeder 10 in zusammengedrücktem Zustand gezeigt.

Die stiftförmige Führung 8 ist gemäß Fig. 1 und 2 mit einer Rastnase 12 versehen, die ein Freikommen der Leiterplatte 6 von der Führung 8 infolge der Kraft der Feder 10 verhindert. Wie weiter in Fig. 1 und 2 gezeigt ist, ist an dem Deckel 2 ein Anschlag 14 ausgebildet, der in dieser Ausführungsform eine rohrförmige Form hat. Dieser Anschlag 14 umgreift in aufgesetztem Zustand des Deckels 2 die Führung 8. Das in Fig. 1 besser zu erkennende untere Ende des Anschlags 14 liegt auf der Leiterplatte 6 auf. Diese rohrförmige Form des Anschlags 14 hat den Vorteil, dass nur eine geringe Biegelast auf die Leiterplatte aufgebracht wird, weil der Anschlag 14 im wesentlichen koaxial auf die Spiralfeder 10 unter Zwischenschaltung der Leiterplatte einwirkt.

Des weiteren ist in Fig. 2 eine Rastnase 22 gezeigt, die an dem Träger 4 ausgebildet ist. Eine passende Ausnehmung (nicht gezeigt) in dem Deckel 2 ist ausgelegt, die in Fig. 2 gezeigte Rastnase 22 im Montagezustand des Deckels 2 aufzunehmen. Mit anderen Worten, der von oben auf den Träger 4 aufgesetzte Deckel rastet in dieser Stellung mittels der Rastnase 22 an dem Träger 4 ein. Es können mehrere Rastnasen 22 an dem Träger vorgesehen sein, wie beispielsweise aus Fig. 1 zu erkennen ist.

Die Kraft und der Durchmesser der Spiralfeder 10 sind so bemessen, dass die Kraft der Feder 10 ausreicht, um die Leiterplatte 6 mit hinreichender Kraft gegen den Anschlag 14 des Deckels 2 zu drücken. Gleichzeitig ist der Durchmesser der Spiralfeder 10 so gewählt, dass sie unter Passieren der Rastnase 12 in Fig. 2 auf die Führung 8 aufgesetzt werden kann und dort im aufgesetzten Zustand durch die Rastnase 12 unverlierbar gehalten ist. Die Kraft der Feder ist ferner so bemessen, dass die Leiterplatte 6 von Hand, d.h. ohne weiteres Werkzeug, auf die Führungen 8 aufgedrückt werden kann, bis sie die Rastnasen 12 passiert hat und dadurch an den Führungen 8 gehalten ist.

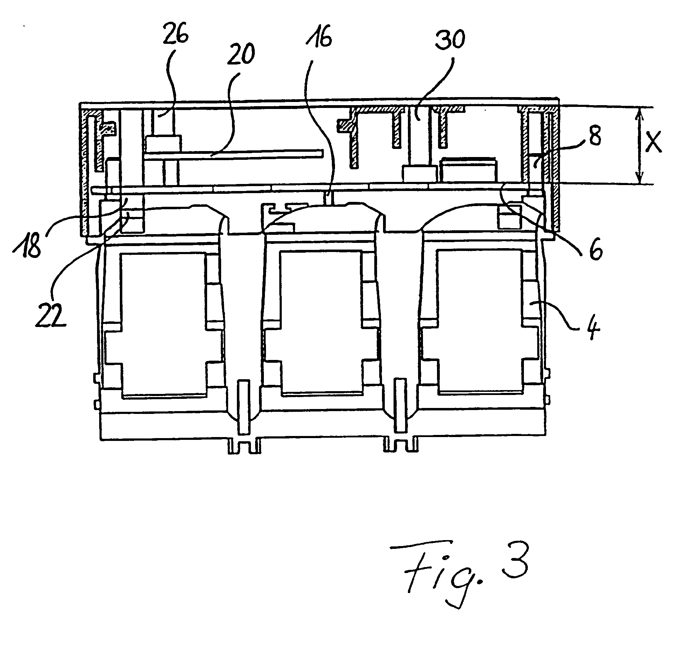

In Fig. 3 ist eine Schnittansicht der in Fig. 1 gezeigten Auslöseeinheit 1 gezeigt. Wie aus Fig. 3 hervorgeht, ist an dem Träger 4 eine Stütze 18 ausgebildet, die von der Seite des Trägers 4 mit der Leiterplatte 6 im Montagezustand in Eingriff gelangen kann, wenn die Leiterplatte 6 gegen die Kraft der Spiralfeder 10 abwärts gedrückt wird. Weil beim Aufrasten des Deckels 2 auf die Rastnasen 22 des Trägers 4 konzentriert Kraft auf diese Stelle ausgeübt wird, ist hier die Stütze 18 einstückig mit der Rastnase 22 ausgebildet.

Ferner ist in Fig. 3 noch eine Stütze 16 gezeigt, die die Leiterplatte 6 etwa mittig abstützt. Mit der Stütze 16 wird vermieden, dass die Leiterplatte 6 beim Einsetzen eines Bereichseinstellelements 20 oder bei der Betätigung der Einstellstifte 26 oder 30 stark verbogen wird, wodurch die Leiterbahnen oder die auf der Leiterplatte befindlichen Elemente zerstört bzw. beschädigt werden könnten.

Wie aus Fig. 3 weiterhin deutlich wird, ist der zwischen dem Deckel 2 und der Leiterplatte 6 einzuhaltende Abstand X durch die Länge des Anschlages 14 in Fig. 1 und 2 festgelegt, so dass Dickenabweichungen der Leiterplatte 6 oder Maßabweichungen des Trägers 4 keinen Einfluss auf den mit X bezeichneten Sollabstand zwischen der Leiterplatte 6 und dem Deckel 2 haben.

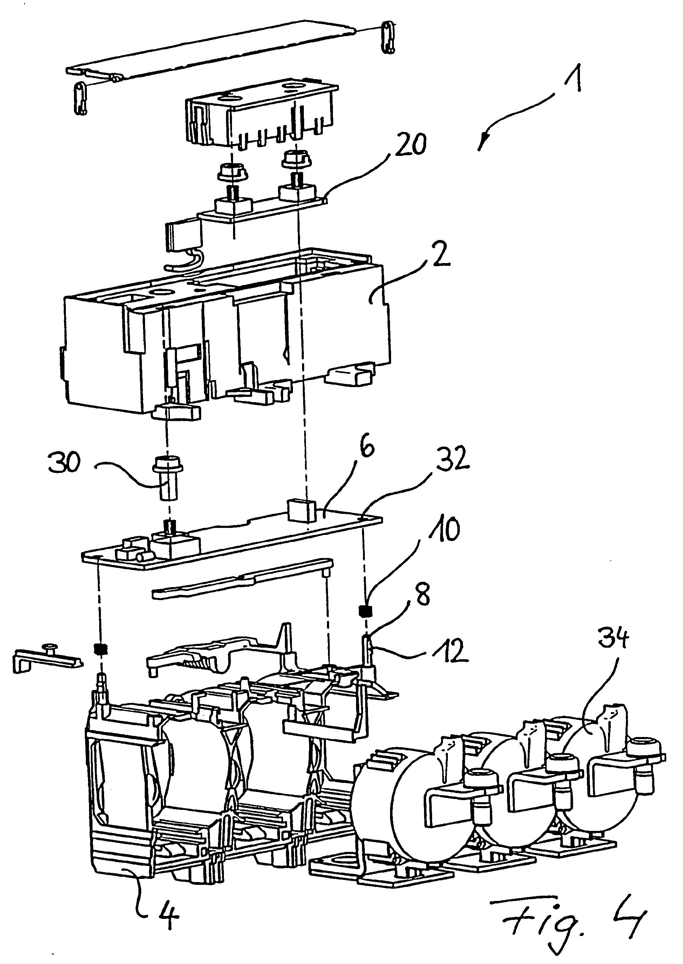

In Fig. 4 ist die gesamte Auslöseeinheit 1 in einer Explosionsdarstellung gezeigt. Fig. 4 zeigt einen Träger 4, der einen im wesentliche quaderförmige Gestalt hat. Der Träger hat ein allgemein C-förmiges Profil, das von einer Basiswand auf der in Fig. 4 gezeigten Rückseite und sich an den oberen und unteren Rand der Basiswand anschließenden Wänden begrenzt ist. Zwischen den beiden Wänden erstrecken sich im wesentlichen in senkrechter Richtung in Fig. 4 Trennwände, die Nischen begrenzen. Die Nischen sind ausgelegt, die in Fig. 4 gezeigten Stromwandler 34 aufzunehmen. Dazu sind die Trennwände passend gekrümmt, um sich der Kontur der Stromwandler anzupassen. Im unteren Bereich der Trennwände und an den Schmalseiten sind Führungen und Rastmittel vorgesehen, um die Stromwandler in den Nischen sicher zu führen und festzulegen. Auf der oberen der beiden Wände sind Führungen 8 ausgebildet. Die Führungen haben im wesentlichen die Form eines zylindrischen Stifts und erstrecken sich senkrecht zur Hauptebene der oberen Wand. Ferner ist auf der oberen Wand eine Stütze (16 in Fig. 3) ausgebildet. Die Stütze hat die Form eines Stegs oder einer Platte, deren Stirnfläche eine Anlagefläche bildet. Ferner ist an der oberen Wand eine Aufnehmung für eine in Fig. 4 gezeigte Schaltwippe ausgebildet, die hier jedoch nicht näher erläutert wird.

In Fig. 4 oberhalb des Trägers 4 ist eine Leiterplatte 6 gezeigt. Die Leiterplatte 6 ist mit elektrischen oder elektronischen Bauteilen bestückt, die hier nur schematisch dargestellt sind. Insbesondere ist ein Einstellglied gezeigt, auf das der Einstellstift 30 aufgesetzt werden kann, so dass er sich bezüglich der Leiterplatte 6 senkrecht nach oben erstreckt. Ferner hat die Leiterplatte 6 in zwei einander diagonal gegenüberliegenden Ecken eine Bohrung 32. Die Bohrung 32 ist eine Durchgangsbohrung, die so bemessen ist, dass die Führungen 8 mit den daran ausgebildeten Rastnasen 12 die Bohrungen 32 in Fig. 4 von unten nach oben passieren können. Die umgekehrte Bewegung, d.h. das Abziehen der Leiterplatte 6 von den Führungen 8 nach oben in Fig. 4 ist durch die Rastnasen 12 verhindert, die mit dem Rand der Bohrungen 32 jeweils in Eingriff sind. Ferner zeigt Fig. 4 die Spiralfedern 10, die ebenfalls unter Passieren der Rastnasen 12 auf die Führungen 8 aufsteckbar sind und in dieser Position durch die Rastnasen 12 gehalten sind.

Oberhalb der Leiterplatte 6 ist in Fig. 4 ein Deckel 2 gezeigt. Der Deckel ist im wesentlichen kastenförmig ausgebildet und ist an seiner in Fig. 4 unteren Seite offen. Der Deckel 2 ist ausgelegt, über die Leiterplatte gestülpt und mit dem Träger in Eingriff gebracht zu werden. In der Einbaulage ist der Deckel mit Rastmitteln (hier nicht gezeigt) gehalten. Oberhalb des Deckels 2 ist in Fig. 4 ein Bereichseinstellelement 20 angedeutet. Dieses Bereichseinstellelement kann mit der Leiterplatte 6 verbunden werden, indem es durch eine in dem Deckel vorgesehen Öffnung in Fig. 4 von oben durch den Deckel hindurchgeführt und auf die Leiterplatte aufgesteckt werden kann. Oberhalb des Bereichseinstellelements 20 ist in Fig. 4 ferner eine Schutzkappe angedeutet, die in die vorgenannte Öffnung des Deckels eingesetzt werden kann. Die Schutzkappe kann Öffnungen haben, um einen Zugriff auf das Bereichseinstellelement zu ermöglichen. Es kann natürlich auch eine geschlossene Schutzkappe sein, die auch eingesteckt werden kann, wenn kein Bereichseinstellelement vorgesehen ist, um die vorgenannte Öffnung in dem Deckel 2 zu verschließen. Die Schutzkappe ist mit Rastmitteln versehen, die wahlweise lösbar oder unlösbar ausgeführt sein können. Dadurch kann gegebenenfalls ein unbefugter Zugriff auf das Bereichseinstellelement verhindert werden.

Ganz oben in Fig. 4 ist noch eine Klappe zusammen mit zwei Scharnierelementen gezeigt. Die Scharnierelemente können entlang der strichpunktierten Line parallel zu der Klappe auf an der Klappe ausgebildete Zapfen aufgesetzt werden. Die Scharnierelemente können in auf der Oberseite des Deckels vorgesehen Öffnungen eingeführt und darin befestigt werden. Somit kann eine Klappe zur Abdeckung der Oberseite des Deckels auf leichte Weise an dem Deckel 2 vorgesehen werden.

In dieser Figur ist gut zu erkennen, dass die Führungen 8 mit den Rastnasen 12 an dem Träger 4 ausgebildet sind. Der Träger 4 ist ausgelegt, sogenannte Stromwandler 34 aufzunehmen, die mit der Leiterplatte 6 elektrisch verbunden werden sollen. Ferner ist in Fig. 4 die Spiralfeder mit 10 bezeichnet und in der Leiterplatte 6 ausgebildete Bohrungen als die Führungsaufnahmen sind mit 32 bezeichnet. Wie aus Fig. 4 deutlich wird, sind die Bohrungen 32 an zwei diagonal gegenüberliegenden Ecken der Leiterplatte 6 ausgebildet. An dem Träger 4 sind die entsprechenden Führungen 8 ausgebildet. Zwei der Führungen, die mit den Bohrungen 32 der Leiterplatte 6 zusammenwirken, haben sich als ausreichend erwiesen, es können jedoch auch mehr als 2 Führungen und zugeordnete Bohrungen in der Leiterplatte vorgesehen werden.

Ferner zeigt Fig. 4 den über die Baugruppe aus Träger 4 und Leiterplatte 6 zu stülpenden Deckel 2. In Fig. 4 ist das Bereichseinstellelement 20 gezeigt, das sich in Fig. 3 wiederfindet. Wie aus Fig. 3 zu erkennen ist, ist das Bereichseinstellelement 20 an seiner Unterseite mit einem Stecker (nur schematisch gezeigt) versehen, um auf die Leiterplatte 6 aufgesteckt zu werden und sich parallel zu dieser zu erstrecken. Das Bereichseinstellelement 20 dient dazu, die Leiterplatte 6 einer gewünschten Arbeitsweise der Auslöseeinheit 1 anzupassen.

Anhand der Fig. 4 wird nachfolgend der Montage- oder Zusammenbauvorgang für die gezeigte Auslöseeinheit 1 erläutert werden.

Ein Träger 4 wird an seinen Führungen 8 mit Spiralfedern 10 versehen und die Stromwandler 34 werden in die zugehörigen Nischen in dem Träger 4 eingesetzt. Anschließend wird die Leiterplatte 6 mit ihren Bohrungen 32 über die Führungen 8 geführt und in Richtung auf den Träger gedrückt, bis die Rastnasen 12 auf der in Fig. 4 oberen Seite der Leiterplatte 6 verriegeln. Dadurch ist die Leiterplatte zunächst mechanisch sicher an dem Träger 4 gehalten.

Nun kann die Verdrahtung der Leiterplatte 6 mit den Stromwandlern 34 erfolgen, indem an den Stromwandlern 34 vorgesehene Verbindungsdrähte oder Leitungsdrähte (nicht gezeigt) mit geeigneten Anschlusspunkten auf der Leiterplatte 6 verbunden werden. Weil die mechanische Zuordnung zwischen den Stromwandlern 34 und der Leiterplatte 6 bereits durch deren jeweilige Verbindung mit dem Träger 4 festgelegt ist, können dünne und entsprechend der Ströme bemessene Leitungsdrähte für den Anschluss verwendet werden.

Ferner können einfache Verbindungstechniken für die Leitungsanbindung bzw. den elektrischen Anschluss der Leitungsdrähte an die Leiterplatte 6 verwendet werden; dies sind insbesondere die Crimptechnik oder eine Quetschverbindungstechnik. Mit anderen Worten, eine teure, aufwendige Handlötung, die besondere Festigkeitskriterien erfüllt, ist nicht erforderlich. Weil die Leiterplatte 6 und die Stromwandler 34 im wesentlichen fest einander zugeordnet sind, können entsprechend kurz bemessene Leitungsdrähte verwendet werden, deren Unterbringung in dem Gehäuse oder im Träger keine Schwierigkeiten bereitet.

Anschließend wird der Deckel 2 von oben über die Leiterplatte gestülpt, wobei, wie in Fig. 1 gezeigt ist, der Anschlag 14 über die Führungen 8 gebracht oder gestülpt wird. Dieser Führung folgend, wird der Deckel gegen die Kraft der beiden Spiralfedern 10 niedergedrückt, bis die Rastnasen 22 gemäß Fig. 2 in zugehörigen Ausnehmungen (nicht gezeigt) im Deckel 2 einrasten.

Anschließend können im Bedarfsfall die entsprechenden Bereichseinstellelemente 20 durch die mit 28 in Fig. 1 bezeichnete Öffnung auf die Leiterplatte 6 aufgesteckt werden. Es können auch weitere Einstellelemente, Prüfelemente, etc. mit der Leiterplatte verbunden werden, dies kann beispielsweise durch die Öffnung 38 in Fig. 2 erfolgen.

Wie in Fig. 4 gezeigt ist, kann optional auf die so montierte Baugruppe gegebenenfalls noch eine Klappe mit passenden Scharnieren aufgesetzt werden.

Zuvor wurde die Erfindung im einzelnen anhand eines bevorzugten Ausführungsbeispiels genau erläutert. Es sind jedoch insbesondere die nachfolgenden Modifikationen möglich, ohne den Bereich der Erfindung zu verlassen.

Die im vorhergehenden Ausführungsbeispiel stiftförmigen Führungen 8 können beispielsweise durch sich von dem Träger weg erstreckende Laschen ersetzt sein, die die Leiterplatte an ihren Seitenkanten führen. Die Laschen können einzelne Laschen sein, es ist aber auch möglich, an beispielsweise zwei Ecken der Leiterplatte entsprechende winkelförmige Profile vorzusehen, die zwei Seitenkanten der Leiterplatte gleichzeitig erfassen. Ebenso ist es möglich, an beiden Schmalseiten der Leiterplatte beispielsweise ein Führungsprofil vorzusehen, das die gesamte Schmalseite sowie einen Abschnitt der daran angrenzenden Seitenkanten mit erfasst und führt.

Die Spiralfeder 10 als das federnde Element kann ebenfalls durch gleichwirkende Mittel ersetzt werden. Dies kann insbesondere ein an der dem Träger zugewandten Seite der Leiterplatte angebrachtes Federelement sein, wie beispielsweise eine oder mehrere Federspangen oder Zungen, die an der Leiterplatte angenietet oder angelötet sind. Ferner kann bei der Ausbildung der Führungen an dem Träger selbst ein federndes Kunststoffelement oder eine Federlasche direkt mit ausgebildet oder angeformt werden, so dass die Anzahl der Teile weiter vermindert ist.

Die Rasteinrichtung an den Führungen kann beispielsweise eine in dem vorhergehenden Ausführungsbeispiel gezeigte Rastnase an den Führungen sein, es können aber auch andere bekannte Mittel oder Formen für solche Rasteinrichtungen an den Führungen verwendet werden. Ferner können auch andere Befestigungsmittel verwendet werden, um die Leiterplatte an den Führungen festzulegen. Diese umfassen auch ein Verformen des Spitzenendes der Führungen nach dem Aufsetzen der Leiterplatte auf die Führungen. Das Verformen kann auch durch gezieltes Erweichen des Materials der Führungen (Warmverformen) und anschließende Deformation des erweichten Abschnitts erfolgen.

## Patentansprüche

1. Vorrichtung zur lagerichtigen Befestigung einer Leiterplatte (6) zwischen einem zusammengebauten Träger (4) und einem zusammengebauten Deckel (2), mit
an dem Träger (4) vorgesehenen Führungen (8), die mit Führungsaufnahmen (32) der Leiterplatte in Eingriff sind,
mindestens einem federnden Element (10), das die Leiterplatte (6) in Erstreckungsrichtung der Führungen (8) vorspannt, und
einem an dem Deckel (2) ausgebildeten Anschlag (14), der die Leiterplatte (6) gegen die Kraft des federnden Elements (10) beaufschlagt, wobei die Führungen (8) und die Führungsaufnahmen (32) mit einer Rasteinrichtung (12) versehen sind, die die Leiterplatte (6) gegen Freikommen aus den Führungen (8) sichert.

2. Vorrichtung nach Anspruch 1, **dadurch gekennzeichnet, dass** die Führungen von dem Träger (4) vorstehende Stifte (8) sind und die Führungsaufnahmen Öffnungen (32) in der Leiterplatte (6) sind, die von den Stiften (8) durchgriffen sind.

3. Vorrichtung nach Anspruch 2, **dadurch gekennzeichnet, dass** die Rasteinrichtung eine endseitig der Stifte (8) ausgebildete Rastnase (12) ist, die mit einem Rand der Öffnung (32) zusammenwirkt.

4. Vorrichtung nach Anspruch 1, **dadurch gekennzeichnet, dass** die Führungen (8) von dem Träger (4) vorstehende Laschen sind, die jeweils an mindestens einer Seitenkante der Leiterplatte (6) als die Führungsaufnahme anliegen.

5. Vorrichtung nach einem der vorhergehenden Ansprüche 1 bis 4, **dadurch gekennzeichnet, dass** das federnde Element (10) zwischen dem Träger (4) und der Leiterplatte (6) angeordnet ist und die Leiterplatte (6) in Richtung auf den Deckel (2) vorspannt.

6. Vorrichtung nach Anspruch 1 bis 3 und 5, **dadurch gekennzeichnet, dass** das federnde Element eine Spiralfeder (10) ist, die um die Führungen (8) gewunden ist.

7. Vorrichtung nach Anspruch 6, **dadurch gekennzeichnet, dass** die Spiralfeder (10) von der Rasteinrichtung (12) der Führung an der Führung (8) gehalten ist.

8. Vorrichtung nach Anspruch 4 und 5, **dadurch gekennzeichnet, dass** das federnde Element (10) eine Federzunge ist, die an der Leiterplatte (6) oder an dem Träger (4) angebracht ist.

9. Vorrichtung nach Anspruch 8, **dadurch gekennzeichnet, dass** die Federzunge an dem Träger (4) oder an den Führungen (8) des Trägers angeformt ist.

## Claims

1. Device for fixing a printed circuit board (6) in correct position between an assembled support (4) and an assembled cover (2), with
guides (8) provided on the support (4) which engage with guide recesses (32) in the printed circuit board,
at least one spring element (10) which pre-tensions the printed circuit board (6) in the direction of extension of the guides (8), and
a stop (14) formed on the cover (2) which supports the printed circuit board (6) against the pressure of the spring element (10), whereby the guides (8) and the guide recesses (32) are provided with a snap-locking element (12) which secures the printed circuit board (6) against becoming detached from the guides (8).

2. Device according to claim 1, **characterised in that** the guides are pins (8) projecting from the support (4) and the guide recesses are openings (32) in the printed circuit board (6) through which the pins (8) penetrate.

3. Device according to claim 2, **characterised in that** snap-locking element is a snap tab (12) formed on the end of the pins (8) which interacts with an edge of the opening (32).

4. Device according to claim 1, **characterised in that** the guides (8) are lugs projecting from the support (4) which each lie against at least one side edge of the printed circuit board (6), serving as the guide recess.

5. Device according to one of the preceding claims 1 to 4, **characterised in that** the spring element (10) is arranged between the support (4) and the printed circuit board (6) and pre-tensions the printed circuit board (6) in the direction of the cover (2).

6. Device according to claims 1 to 3 and 5, **characterised in that** the spring element is a spiral spring which is wound around the guides (8).

7. Device according to claim 6, **characterised in that** the spiral spring (10) is held to the guide (8) by the snap-locking element (12) of the guide.

8. Device according to claims 4 and 5, **characterised in that** the spring element (10) is a spring tab which is attached to the printed circuit board (6) or to the support (4).

9. Device according to claim 8, **characterised in that** the spring tab is moulded on the support (4) or on the guides (8) of the support.

## Revendications

1. Dispositif de fixation en position correcte d'une plaquette de circuits imprimés (6) entre un support (4) assemblé et un couvercle (2) assemblé, dans lequel sur le support (4) sont prévus des guidages (8) en prise avec des logements de guidage (32) de la plaquette de circuits imprimés (6), au moins un élément élastique (10) précontraint la plaquette de circuits imprimés (6) dans la direction définie par le guidage (8), et le couvercle (2) présente une butée (14) qui agit sur la plaquette de circuits imprimés (6) contre la force de l'élément élastique (10), les guidages (8) et leurs logements (32) étant équipés d'un dispositif d'arrêt (12) qui met la plaquette de circuits imprimés (6) à l'abri d'un dégagement des guidages (8).

2. Dispositif selon la revendication 1, **caractérisé en ce que** les guidages sont des broches (8) faisant saillie sur le support (4) et les logements des guidages sont des ouvertures (32) pratiquées dans la plaquette de circuits imprimés (6) et que traversent les broches (8).

3. Dispositif selon la revendication 2, **caractérisé en ce que** le dispositif d'arrêt est un cran d'arrêt (12) qui est réalisé dans chaque broche (8) vers l'extrémité de celle-ci et qui coopère avec un bord de l'ouverture (32).

4. Dispositif selon la revendication 1, **caractérisé en ce que** les guidages (8) sont des pattes qui font saillie sur le support (4) et qui sont en contact chacune avec au moins un bord latéral de la plaquette de circuits imprimés (6) servant d'accueil de guidage.

5. Dispositif selon une des revendications précédentes, **caractérisé en ce que** l'élément élastique (10) est disposé entre le support (4) et la plaquette de circuits imprimés (6), celle-ci étant précontrainte en direction du couvercle (2).

6. Dispositif selon une des revendications 1 à 3 et 5, **caractérisé en ce que** l'élément élastique est un ressort à boudin (10) enroulé autour des guidages (8).

7. Dispositif selon la revendication 6, **caractérisé en ce que** le ressort à boudin (10) est maintenu sur le guidage (8) par le dispositif d'arrêt (12) de celui-ci.

8. Dispositif selon les revendications 4 et 5, **caractérisé en ce que** l'élément élastique (10) est une languette élastique montée sur la plaquette de circuits imprimés (6) ou sur le support (4).

9. Dispositif selon la revendication 8, **caractérisé en ce que** la languette élastique est moulée sur le support (4) ou sur les guidage (8) de celui-ci.
